# EUROPEAN PATENT APPLICATION

(11) **EP 1 792 553 A2**
(43) Date of publication of application: **06.06.2007**
(21) Application number: 06251516.8
(22) Date of filing: 22.03.2006
(51) Int. Cl.: A47G 1/02

(54) **Illuminated mirror**

(30) Priority: 03.12.2005 GB 0524729
(71) Applicant: Dar Lighting Ltd., Banbury, Oxfordshire OX16 3JZ (GB)
(72) Inventor: Buckingham, Stephen Arthur, Warwickshire CV37 6BD (GB)
(74) Representative: Stanley, Michael Gordon

(57) **Abstract**

An illuminated mirror assembly (10) comprising at least one electrical light source (15) assembled to a mirror (11), the light source having a switch (31) which is switched between on and off conditions by a proximity sensor (33) operated by contact with or proximity to a person wishing to use the mirror. The sensor (33) is an infra red optical movement sensor for sensing movement within a restricted zone in front of the mirror of about 10cms.

## Description

### Field

This invention relates to illuminated mirrors of the type in which an electrical light source is mounted on the mirror, and which are typically used in bathrooms.

### Background of the Invention

Illuminated mirrors are frequently used in bathrooms and bedrooms, and when used in bathrooms are, for reasons of safety, typically switched on and off by a cord operated pull switch. When used, in bathrooms or shower rooms its is necessary for the electrical fittings of the mirror to meet the moisture ingress standards laid down in BS EN 60598 IP44.

There is a recent trend for illuminated mirrors to be supplied as a single units with the light(s) mounted on mirrors and with any housing, containing the electrical components, being assembled to the mirror, typically the reverse side of the mirror. Similarly, the illuminated mirror may form part of a bathroom cabinet or cupboard.

It is known for outside security lights to be switched on by infrared sensor operated switches and its is also known in some large toilet facilities, for infrared movement sensors to operate devices for flushing toilets, to control the water supply to a hand wash facility, and/or operate hand driers.

### Object of the Invention

The present invention provides a new and improved illuminated mirror having an electrical light source than can be switched on and off with maximum safety.

### Statement of the Invention

According to the present invention there is provided an illuminated mirror assembly, typically for use in a bathroom, with at least one electrical light source assembled to a mirror, the light source having a switch which is switched between on and off conditions by a proximity sensor operated by contact with or proximity to a person wishing to use the mirror

Preferably the proximity sensor is an optical movement sensor for sensing movement within a restricted zone in front of the mirror.

Since the mirror light can be switched on and off merely by movement of the hand in front of the sensor the safety of the assembly is improved since the switch requires no direct contact for operation, and since no aperture need be provided for operation of the switch there is an increased barrier to moisture ingress. Furthermore, with no provision to be made for cord operated switches, the assembly is more aesthetic.

The sensor is preferably an infrared sensor and which may sense movement up to a distance of 10cms (4.0inches) in front of the mirror.

The sensor is held behind the mirror in any desired location with a portion of the mirror coat on the rear surface of the mirror being removed to allow the sensor to detect movement through the mirror glazing. The term glazing applies to any suitable transparent material from which a mirror may be formed, for example but not limited to glass, acrylic sheet, polyethylene teraphthallate (PET) sheet and polycarbonate sheet.

The sensor is held in contact with the rear surface of the mirror glazing by resilient means, preferably a spring clip, which may be mounted on the mirror coat using a suitable adhesive which does not attack the coating.

The mirror assembly includes a housing enclosing said at least one light source the housing being sealingly mounted on the rear of the mirror. The housing may be formed from any suitable material.

In an alternative arrangement, the proximity sensor may comprise a touch sensor which is responsive to contact by the user. The touch sensor may be an electrically conductive surface which on a non conductive mirror surround or housing may be provided by a conductive metal pad, or in the case of a metallic housing, for example a chrome plated or stainless steel housing , selective areas of the housing may be used as the touch sensor, or the whole surface area of housing.

The housing may include a transformer which provides electrical power for the light source, and a switch which is controlled by to switch the power supply to the transformer on and off The switch may comprise a dimmer switch which operates to produce different stages of brightness, or continuously dims or brightens.

Preferably, each light source aligns with a lens having an inner portion inserted into a respective aperture in the mirror glazing, with the inner surface of each lens, that the surface adjacent the light source, being made translucent, by for example a frosted surface. The outer portion of each lens stands proud of the mirror external surface and may overlap the edges of the aperture. The inner portion may be circular in section being a slide fit its respective aperture, and the outer portion may be any desired shape, for example any polygonal shape.

The mirror assembly may be a stand alone unit for mounting directly on a wall or other support surface, or may form part of a cabinet, cupboard or wardrobe.

### Description of the Drawings

The Invention will be described by way of Example and with reference to the accompanying drawings in which:
- Fig. 1: is front view of a mirror assembly according to the present invention,
- Fig. 2: is a section on the line II-II of Fig. 1,
- Fig. 3: is an enlarged section on a portion of the line II-II showing the sensor and holder in greater detail,
- Fig.4: is a rear view of the mirror,
- Fig. 5: is a schematic electrical circuit for the mirror assembly, and
- Fig.6: is a second schematic electrical circuit.

### Detailed Description of the Invention

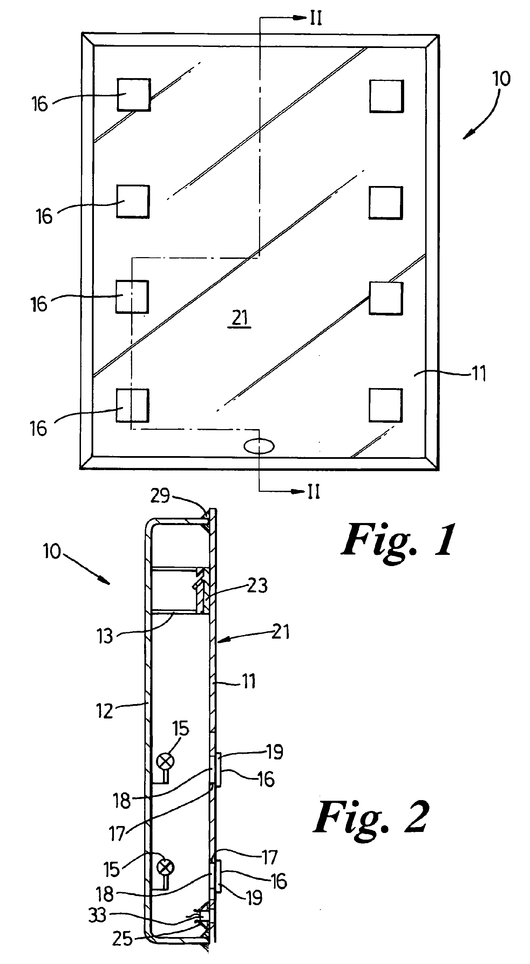

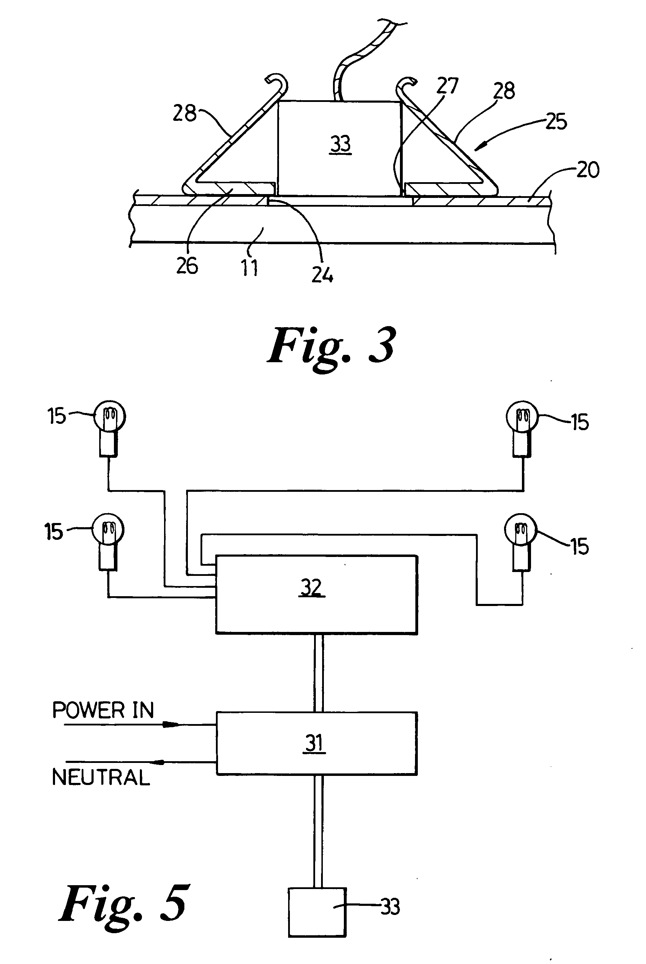

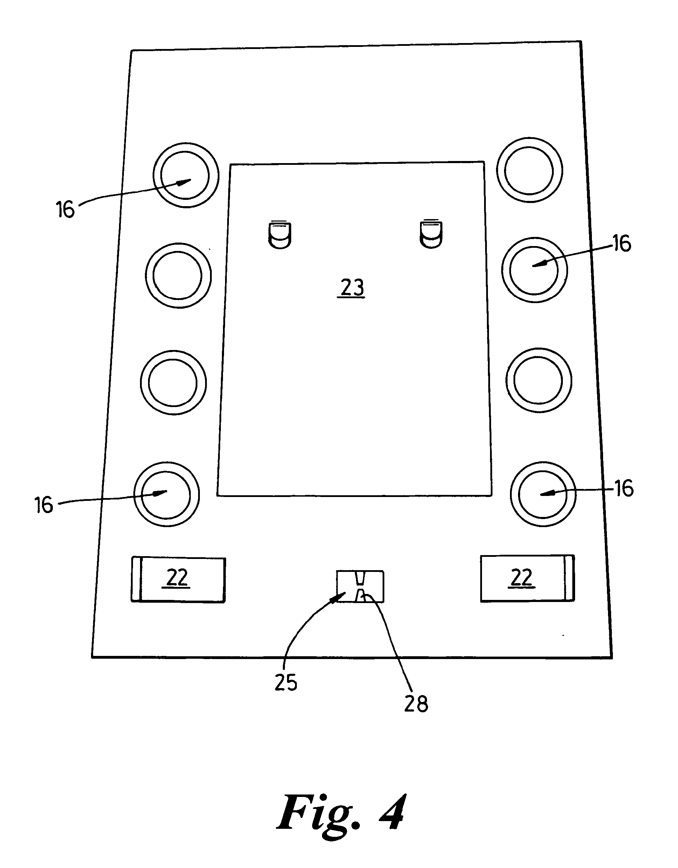

With reference to figures 1, 2 & 4, there is shown a mirror assembly 10 according to the present invention. The assembly comprises a planar mirror 11 with a housing 12 secured to the rear of the mirror 11. The mirror I 1 may be made from any suitable material and may be any desired shape, in this example the mirror is rectangular. In the preferred embodiment the mirror is formed from a transparent sheet glazing material, for example glass with the rear of the mirror covered by a mirror coat 20 (see fig.3).

A plurality of light bulbs 15 are mounted within the housing 12 together with the electrical system for controlling the illumination of the bulbs. In the present example there are six light bulbs 15 but any number of bulbs as is desired may be used. The bulbs 15 are arranged in alignment with respective lenses 16 which are inserted into respective apertures 17, preferably circular apertures, formed in the mirror. In the present example, the lenses 16 are each formed from a circular cross-section inner portion 18 and an outer portion 19 which stands proud of the front surface 21 of the mirror 11. The inner surface of each lens 17 may be frosted to diffuse and scatter light from the respective bulbs. The outer portions 19 of the lenses may be any desired shape, in this example square, and may be all of the same shape or of differing shapes.

Brackets 22,23 for assembly of the mirror 11 to the housing 12 are adhered to the mirror coat 20 by a suitable adhesive, for example a silicone based adhesive, which does not attack the mirror coat. A bracket 13 secured within the housing 13 serves to hold the mirror 11 in assembly with the housing. A gasket 29 seals between the mouth of the housing and the rear surface of the mirror.

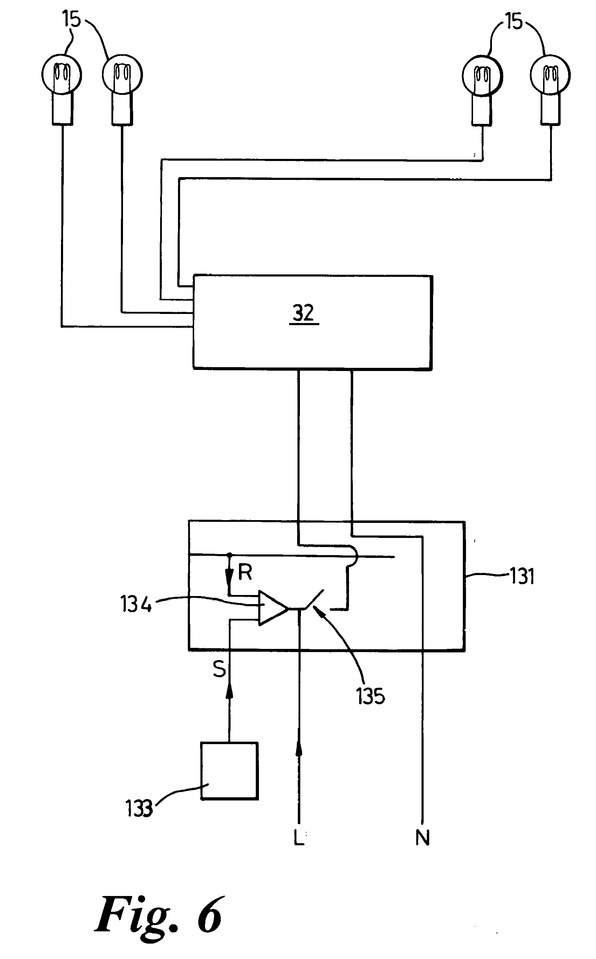

The electrical system for the light bulbs 15 is shown in Fig 5 and in Fig 6. The power (220/240v 50 Hz AC) to the light bulbs 15 is supplied through a switch 31,131 operated by a proximity sensor 33,133 the proximity of a person wishing to use the mirror when illuminated. As shown in Fig.5, the switch 31 to an infra red sensor switch 31 ( part no. JV2100JR available from Jing Neng ). The switch 31 is connected to a transformer 32 with a 12V DC output to a plurality of light bulbs 15. The on/off condition of the switch 31 is controlled by a infrared movement sensor 33.

The sensor 33 is mounted on the rear of the mirror 11 in any desired location, by means of a resilient spring clip 25 adhered to the mirror coat 20. The spring clip 25 is shown in detail in Fig.3 and is a stainless steel pressing comprising a flat base 26 having a central aperture 27 therein shaped to accommodate the sensor 33. A pair of resilient limbs 28 are formed integrally with the base 26 and in use hold the sensor 33 against the rear of the mirror. The clip 25 is arranged on the rear of the mirror so that the aperture 27 aligns with an aperture 24 formed in the mirror coat 20 and which allows the sensor 33 to detect movement through the transparent glazing material. The limbs 28 press and hold the "eye" of the sensor 33 in contact with the glazing material.

In use , the housing is fixed to a support surface, such as a wall, and the mirror 11 is assembled to the housing 12 with the gasket 29 sealing between the housing and the rear surface of the mirror. The bracket 23 on the mirror engages the co-operating bracket 13 in the housing and the brackets 22 on the mirror engage with the sides of the housing. The sensor 33 faces forwardly through the mirror glazing.

In order that the mirror illuminations are not frequently turned on and off by miscellaneous and irrelevant movements the sensor 33 is sensitive only to movements within a predetermined distance in front of the mirror, preferably a distance of about 10cms. In use, it will be necessary to pass the hand immediately in front of the senor aperture 24 to activate the switch 31.

In an alternative arrangement shown in Figure 6, the switch is a touch sensitive switch 131 (type TTD-1 available from Yuan Chi Co. Ltd of China) which is operated through an electrical conductive sensor 133. The sensor 133 which fitted to a non conductive housing 12 may comprise a conductive metal pad. Where the housing 12 is formed of a conductive material, or is covered in a conductive layer, either over its whole surface area, or in selected area, the surface may act as the contact sensor 133.

Contact of the user with the sensor 133 generates an electrical signal S which passes to a comparator 134 in the switch 131. The comparator 134 compares the signal S with a reference R and in specified conditions closes a contact 135 to allow electrical power to pass to the transformer 32.

The switches 31/131 may also include comprise a dimmer switch which operates to produce different powers of illumination, either in discrete levels of illumination or continuously, dimming or brightening as required.

The above mirror assemblies may be used alone or may form part of a bathroom cabinet, wardrobe, cupboard et..

## Claims

1. An illuminated mirror assembly comprising at least one electrical light source assembled to a mirror, the light source having a switch which is switched between on and off conditions, **characterised in that** the switch (31) is operated by a proximity sensor (33) operated by contact with or proximity to a person wishing to use the mirror

2. An assembly as claimed in Claim 1 wherein the sensor (33) is an infra-red optical movement sensor for sensing movement within a restricted zone in front of the mirror.

3. An assembly as claimed in Claim 2, wherein the sensor (33) senses movement up to a distance of 10cms (4.0inches) in front of the mirror.

4. An assembly as claimed in Claim 3 or Claim 4, wherein the sensor (33) is held behind the mirror (11) in any desired location with an aperture (24) provided in the mirror coat (20) on the rear surface of the mirror (11) being to allow the sensor (33) to detect movement through the mirror glazing.

5. An assembly as claimed in Claim 4, wherein the sensor (33) is held in contact with the rear surface of the mirror glazing and is pressed against the surface of the glazing by resilient means (25).

6. An assembly as claimed in Claim 5, wherein the resilient means (25) comprises a spring clip, which is mounted on the mirror coat (20) using a suitable adhesive which does not attack the coating.

7. An assembly as claimed in any one of Claims 1 to 6, further including a housing (12) enclosing said at least one light source (15), the housing being sealingly mounted on the rear of the mirror (11).

8. An assembly as claimed in any one of Claims 1 to 8 wherein the proximity sensor (33) comprises a touch sensor (131) which is responsive to contact by the user.

9. An assembly as claimed in Claim 8, wherein the touch sensor (131) is an electrically conductive surface which on a non conductive mirror surround or housing is provided by a conductive metal pad (133).

10. An assembly as claimed in Claim 8 when dependant upon Claim 7, wherein the housing (12) comprises a conductive metallic housing and at least selective areas of the surface of the housing may be used as the touch sensor.

11. An assembly as claimed in any one of Claims 1 to 10, further including a transformer (32) which provides electrical power for the light source, and a switch (31,131) which is controlled by the sensor (33,133) to switch the power supply to the transformer (32) on and off.

12. An assembly as claimed in Claim 7, wherein each light source (15) aligns with a lens (16) having an inner portion (18) inserted into a respective aperture (17) in the mirror (11) and an outer portion (19) which stands proud of the mirror external surface and overlaps the edges of the aperture (17).

13. An assembly as claimed in claim 12, wherein the inner portion (18) is circular in section being a slide fit its respective aperture (17), and the outer portion (19) is any shape as is desired.

14. An assembly as claimed in Claim 12 or Claim 13, wherein the inner surface of each lens (17), that is the surface adjacent the light source (15), is translucent.

15. An assembly as claimed in any one of Claims 1 to 14 wherein the switch (31,131) comprises a dimmer switch which operates to produce different power of illumination, either dimming or brightening continuously or in discrete levels.
